(19) **Europäisches Patentamt**
European Patent Office
Office européen des brevets

(11) **EP 1 415 393 B1**

(12) **EUROPÄISCHE PATENTSCHRIFT**

(45) Veröffentlichungstag und Bekanntmachung des Hinweises auf die Patenterteilung:
**05.05.2010 Patentblatt 2010/18**

(21) Anmeldenummer: **01953739.8**

(22) Anmeldetag: **08.08.2001**

(51) Int Cl.:
*H03G 7/00* (2006.01) *H04R 25/00* (2006.01)

(86) Internationale Anmeldenummer:
**PCT/CH2001/000484**

(87) Internationale Veröffentlichungsnummer:
**WO 2001/076063 (11.10.2001 Gazette 2001/41)**

(54) **VERFAHREN ZUR VERARBEITUNG EINES EINGANGSSIGNALS ZUR ERZEUGUNG EINES AUSGANGSSIGNALS UND EINE ANWENDUNG DES VERFAHRENS BEI HÖRHILFEN BZW. HÖRGERÄTEN**

METHOD FOR PROCESSING AN INPUT SIGNAL FOR PRODUCING AN OUTPUT SIGNAL AND AN APPLICATION OF SAID METHOD IN HEARING AIDS AND DEVICES

PROCEDE DE TRAITEMENT D'UN SIGNAL D'ENTREE EN VUE DE PRODUIRE UN SIGNAL DE SORTIE ET UTILISATION DE CE PROCEDE DANS LE CAS D'APPAREILS DE CORRECTION AUDITIVE OU DE PROTHESES AUDITIVES

(84) Benannte Vertragsstaaten:
**CH DE DK FR GB IT LI**

(43) Veröffentlichungstag der Anmeldung:
**06.05.2004 Patentblatt 2004/19**

(73) Patentinhaber: **PHONAK AG**
**8712 Stäfa (CH)**

(72) Erfinder: **ROECK, Hans-Ueli**
**CH-8634 Hombrechtikon (CH)**

(74) Vertreter: **Rigling, Peter Daniel**
**Troesch Scheidegger Werner AG**
**Schwäntenmos 14**
**8126 Zumikon (CH)**

(56) Entgegenhaltungen:
**GB-A- 1 599 401 US-A- 4 208 548**

• **PATENT ABSTRACTS OF JAPAN vol. 2000, no. 24, 11. Mai 2001 (2001-05-11) & JP 2001 204098 A (MATSUSHITA ELECTRIC IND CO LTD), 27. Juli 2001 (2001-07-27)**

**Beschreibung**

Die vorliegende Erfindung betrifft ein Verfahren und eine Vorrichtung zur Verarbeitung eines Eingangssignals zur Erzeugung eines Ausgangssignals sowie Anwendungen des Verfahrens und der Vorrichtung bei Hörhilfen und Hörgeräten.

Sogenannte Transientenlimiter sind Signalverarbeitungseinheiten, welche schnell ansteigende, kurzzeitige, d.h. transiente Signalkomponenten ohne Verzögerung, d.h. ohne Überschwingen auf einen vorbestimmbaren Pegel, der im folgenden Schwellwert genannt wird, begrenzen können. Der Schwellwert, an dem der Transientenlimiter in Aktion tritt, ist dabei nicht signalabhängig sondern als Parameter einstellbar.

Transientenlimiter werden beispielsweise in Hörgeräten, welche zur Korrektur eines Hörschadens bei einem Patienten verwendet werden, oder auch in Hörhilfegeräten eingesetzt, die zur Verbesserung des Hörens in speziellen Situationen, beispielsweise bei Abhörvorgängen, verwendet werden. Im folgenden werden unter dem Begriff "Hörhilfen" neben den erwähnten Hörhilfen auch die erwähnten Hörgeräte verstanden. Sollten sich einzelne, im folgenden aufgeführte Erläuterungen auf die Anwendung bei Hörgeräten allein beziehen, so wird dies jeweils ausdrücklich angegeben.

Aufgabe von Transientenlimitern in Hörhilfen ist es zu verhindern, dass der maximale Ausgangspegel der Hörhilfen einen vorgegebenen Schwellwert nicht überschreitet. Dadurch werden Hörhilfeträger vor übermässiger Belastung geschützt.

Die menschliche Sprache weist bekanntlich einen Dynamikbereich von ca. -15 bis +18 dB (Dezibel) um den jeweiligen mittleren Pegel auf, wobei in ruhiger Umgebung, d.h. bei geringen Umgebungsgeräuschen, der mittlere Pegel ca. 60 bis 65 dB beträgt. Bei lauter Umgebung kann der mittlere Pegel auf ca. 80 dB oder mehr ansteigen. Ausgehend von diesen Tatsachen hat man daher die Schwellwerte bei bekannten Verfahren zur Begrenzung von Signalkomponenten bei Normalhörenden auf einen Höchstwert von 100 bis 120 dB fixiert. Bei einem verminderten Hörvermögen wird der Schwellwert entsprechend auf einen oberen Komfortpegel gesetzt, der einem Pegel entspricht, bei dem der Patient noch keine Schmerzen empfindet.

Die menschliche Hörwahrnehmung weist die Eigenart auf, dass nicht nur Pegel, welche über dem maximalen Schwellwert bzw. über dem oberen Komfortpegel liegen, als unangenehm empfunden werden. Tatsächlich werden auch transiente Geräusche (beispielsweise als intermittierender Lärm), welche einen gegenüber dem maximalen Schwellwert deutlich tieferen Pegel aufweisen, als unangenehm empfunden, wenn eine ruhige Umgebung vorherrschend war. So wird ein zum Beispiel durch Geschirr- und Besteckklappern erzeugtes transientes Geräusch in einer ruhigen Umgebung als unangenehm empfunden, obwohl der Pegel deutlich unter dem maximalen Schwellwert von 100 bis 120 Dezibel (dB) liegen kann.

Ein Verfahren zum Begrenzen eines Ausgangssignals ist beispielsweise aus US-4,182,993 bekannt.

Der vorliegenden Erfindung liegt daher die Aufgabe zugrunde, ein Verfahren und eine Vorrichtung anzugeben, bei dem die vorstehend genannten Nachteile nicht auftreten.

Diese Aufgabe wird durch die im kennzeichnenden Teil des Anspruchs 1 angegebenen Massnahmen und durch die im kennzeichnenden Teil des Vorrichtungsanspruchs 9 angegebenen Merkmale gelöst. Vorteilhafte Ausgestaltungen der Erfindung sowie Anwendungen des Verfahrens sind in weiteren Ansprüchen angegeben.

Indem der Schwellwert in Funktion des Pegels des Eingangssignals - d.h. adaptiv - eingestellt wird, können auch transiente Geräusche, deren Pegel deutlich unter dem Höchstwert für den Schwellwert liegen, begrenzt werden, so dass der Komfort des Hörhilfeträgers deutlich gesteigert werden kann.

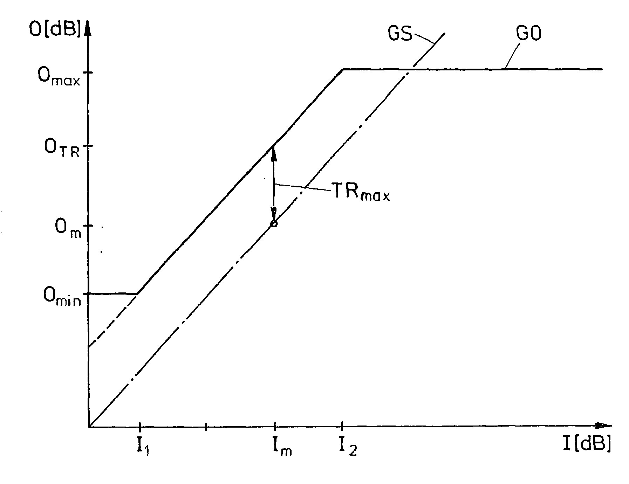

Die Erfindung wird nachfolgend anhand einer Zeichnung beispielsweise näher erläutert. Dabei zeigt die einzige Figur einen Verlauf eines erfindungsgemäss gewählten effektiven Schwellwertes in Funktion eines Pegels des Eingangsignals.

Das erfindungsgemässe Verfahren und dessen Verwendungen werden anhand eines in der einzigen Figur dargestellten Verlaufs eines einzustellenden Schwellwertes in Funktion eines Eingangspegels I erläutert. Dabei wird zunächst von einer normalhörenden Person ausgegangen.

In der Figur wird mit GO eine erfindungsgemässe Schwellwertkurve, welche mit einer festen Linie dargestellt ist, und mit GS eine mittlere Pegelkurve der Eingangssignalpegel, welche strich-punkt-liniert ausgeführt ist, bezeichnet.

Beim erfindungsgemässen Verfahren wird nun laufend ein Schwellwert O bestimmt, der erforderlichenfalls, d.h. wenn der Pegel des Eingangssignals zu hoch ist, zur Begrenzung verwendet wird. Dabei wird davon ausgegangen, dass der momentane Schwellwert O eine Funktion des Pegels I des Eingangssignals ist. Der Schwellwert zur Begrenzung des Eingangssignalpegels wird also laufend den momentan vorherrschenden Gegebenheiten angepasst, mit anderen Worten der Schwellwert wird adaptiv eingestellt.

Zur Einstellung des Schwellwertes O wird vorgeschlagen, zunächst einen momentanen mittleren Pegel I des Eingangssignals zu bestimmen. Dies kann beispielweise mit Hilfe des folgenden Ansatzes erfolgen:

$$ I = \frac{1}{T} \cdot \int_0^T |s(t)| \cdot dt $$

Gemäss dieser Formel wird ein zeitlicher Mittelwert I über den Betrag des Eingangssignal s(t) berechnet, wobei die Mittelwertbildung über ein Zeitintervall T erfolgt, das beispielsweise fünf Sekunden beträgt. Die angegebene Formel eignet sich direkt zur Anwendung bei analogen Systemen. Eine entsprechende Formel kann der Fachmann ohne weiteres auch für digitalen Systeme ableiten.

In einer weiteren Ausführungsvariante des erfindungsgemässen Verfahrens wird vorgeschlagen, dass bei der Bestimmung des mittleren Pegels I des Eingangssignals s(t) lediglich Umgebungsgeräusche, jedoch nicht interessierende Sprachsignale, berücksichtigt werden.

Damit Sprachsignale nicht begrenzt werden, wird weiter vorgeschlagen, den momentanen Schwellwert O um einen Differenzbetrag $TR_{max}$ oberhalb des mittleren Pegels I festzulegen. Vorzugsweise wird der momentane Schwellwert zwanzig Dezibel (dB) oberhalb des mittleren Pegels I festgelegt, womit wegen des erwähnten Dynamikbereichs von Sprachsignale, der von ca. -15 dB bis +18 dB um den mittleren Pegel reicht, eine Begrenzung ausgeschlossen ist.

In der Figur ist mit $I_m$ ein ermittelter mittlerer Pegel des Eingangssignal gemäss vorstehender Formel berechnet worden. Aufgrund des Wertes für den Pegel Im wird ein Schwellwert $O_{TR}$ eingestellt, welcher sich aus einer Addition eines mittleren Ausgangspegels $O_m$ und dem Differenzbetrag $TR_{max}$ bestimmen lässt. Die erfindungsgemässe Bestimmung des momentanen Schwellwerte $O_{TR}$ ergibt einen wesentlichen Komfortgewinn für den Hörhilfeträger, solange sich der mittlere Pegel I innerhalb eines Intervalles $I_1$ bis $I_2$ befindet. Werden mittlere Pegel I des Eingangssignals bestimmt, welche oberhalb des Pegels $I_2$ liegen und wird das soweit beschriebene erfindungsgemässe Verfahren angewendet, so werden Ausgangspegel erhalten, die oberhalb der Schmerzgrenze liegen. Werden auf der anderen Seite mittlere Pegel I des Eingangssignals bestimmt, die unterhalb eines Pegels $I_1$ liegen und wird das soweit beschriebene Verfahren weiter angewendet, so besteht die Gefahr, dass zumindest die ersten gesprochenen Silben abgeschnitten, d.h. begrenzt werden, bevor der mittlere Pegel I wiederum auf höhere Werte ansteigt.

Damit bei lauter Umgebung der effektive Schwellwert O nicht zu hoch wird, ist daher in einer weiteren Ausführungsform des erfindungsgemässen Verfahrens vorgesehen, einen maximalen Schwellwert $O_{max}$ festzulegen, wobei vorzugsweise ein Wert von 120 dB vorgeschlagen wird. In der Figur ist dies durch einen horizontalen Verlauf der Schwellwertkurve GO auf dem Schwellwert $O_{max}$ ersichtlich.

In Weiterführung der vorstehenden Ausführungen ist in einer weiteren Ausführungsform vorgesehen, einen minimalen Schwellwert $O_{min}$ festzulegen, und zwar aus folgendem Grund: In einer ruhigen Umgebung sinkt der mittlere Pegel I rasch auf Werte unterhalb 45 dB ab. Damit würde zumindest die erste Silbe eines Sprechers verschluckt, d.h. begrenzt werden, bevor der mittlere Pegel I wieder auf 60 dB ansteigt. Um dies zu vermeiden, wird der minimale Schwellwert $O_{min}$ festgelegt, und zwar vorzugsweise auf einen Wert von 80 dB. Dies ist dann der kleinste Pegel, der akzeptiert werden muss. In der Figur ist dies wiederum durch einen horizontalen Verlauf der Schwellwertkurve GO auf dem Schwellwert $O_{min}$ ersichtlich.

Wie bereits darauf hingewiesen worden ist, beziehen sich die vorstehenden Ausführungen auf die Anwendung des erfindungsgemässen Verfahren in einer Hörhilfe für einen Normalhörenden. Wird das erfindungsgemässe Verfahren in einem Hörgerät für schwerhörenden Personen eingesetzt, so müssen die Parameterwerte entsprechend angepasst werden.

Entsprechend werden im folgenden weitere Ausführungsvarianten des erfindungsgemässen Verfahrens speziell für Hörgeräte angegeben:

Der minimale Schwellwert $O_{min}$ wird mit einem über den relevanten Bereich gemittelten Verstärkungswert verstärkt. Des weiteren wird der Höchstwert $O_{max}$ für den Schwellwert O auf den jeweiligen oberen Komfortpegel (UCL: upper comfort level) der Person angepasst. Ferner wird der Differenzbetrag $TR_{max}$ einer auf die Person bezogene Kompression eingestellt. Zusammenfassend werden die betroffenen Parameter - nämlich minimaler Schwellwert $O_{min}$, der Höchstwert $O_{max}$ für den Schwellwert O und der Differenzbetrag $TR_{max}$ - in ausgangbezogene Werte umgerechnet. Abhängig von der verwendeten Fittingfunktion wird dabei ein Eingangspegelabhängige Verstärkung auf die Werte $O_{min}$, $O_{max}$ bzw. ein entsprechender Kompressionsfaktor auf $TR_{max}$ angewendet. Typische Kompressionsfaktoren liegen zwischen dem Wert 1 (eins), bei dem keine Kompression vorhanden ist, und dem Wert 4 (vier).

In einer weitere Ausführungsform wird vorgesehen, die Begrenzung des Eingangssignalen entweder weich oder hart vorzunehmen. Bei einer harten Begrenzung wird das Ausgangssignal erst bei Überschreiten des jeweiligen Schwellwertpegels vorzeichenrichtig auf diesen begrenzt. Die Begrenzung kann dabei als ein Kompressionsfaktor betrachtet werden, der unendlich gross ist. Bei einer weichen Begrenzung wird schon vor dem Erreichen des Schwellwertes eine zunehmend grössere Kompression angewendet. Dies führt dazu, dass erzeugte Oberwellen infolge der Verzerrung abgeschwächt werden, die Signalform "runder" aussieht und das derart begrenzte Signal angenehmer klingt.

**Patentansprüche**

1. Verfahren zur Bestimmung eines Schwellwertes ($O_{max}$, $O_{min}$, $O_{TR}$) in einem Hörgerät, wobei der Schwellwert ($O_{max}$, $O_{min}$, $O_{TR}$) zur Begrenzung eines Ausgangssignals einer Verarbeitungseinheit dient, der ein Eingangssignal s(t) zugeführt wird, **dadurch gekennzeichnet, dass** ein Mittelwert eines Pegels des Eingangssignals s(t) bestimmt wird, dass der Schwellwert ($O_{max}$, $O_{min}$, $O_{TR}$) in Funktion des Mittelwertes eingestellt wird, dass das Ausgangssignal im Hörgerät durch Anwenden des Schwellwertes ($O_{max}$, $O_{min}$, $O_{TR}$) limitiert wird, wobei der Schwellwert ($O_{max}$, $O_{min}$, $O_{TR}$) auf einen oberen Wert eingestellt ist, der dem Mittelwert plus einer vorgegebenen Differenz ($TR_{max}$) entspricht, und wobei das Ausgangssignal auf den oberen Wert begrenzt wird, wenn das Ausgangssignal höher wäre als der obere Wert.

2. Verfahren nach Anspruch 1, **dadurch gekennzeichnet, dass** bei der Bestimmung des Mittelwertes des Pegels des Eingangssignals ausschliesslich im Eingangssignal enthaltene Umgebungsgeräusche berücksichtigt werden.

3. Verfahren nach Anspruch 1 oder 2, **dadurch gekennzeichnet, dass** die vorgegebene Differenz ($TR_{max}$) zwanzig Dezibel beträgt.

4. Verfahren nach Anspruch 1 oder 2, **dadurch gekennzeichnet, dass** der Mittelwert aus dem Eingangssignal s(t) nach folgender Formel bestimmt wird:

$$I = \frac{1}{T} \cdot \int_0^T |s(t)| \cdot dt \ ,$$

wobei eine Mittelung über ein Zeitintervall T vorgenommen wird, das vorzugsweise fünf Sekunden beträgt.

5. Verfahren nach einem der Ansprüche 1 bis 4, **dadurch gekennzeichnet, dass** ein maximaler Schwellwert ($O_{max}$) festgelegt wird.

6. Verfahren nach Anspruch 5, **dadurch gekennzeichnet, dass** der maximale Schwellwert ($O_{max}$) gleich einem oberen Komfortpegel einer schwerhörenden Person gewählt wird.

7. Verfahren nach einem der Ansprüche 1 bis 6, **dadurch gekennzeichnet, dass** ein minimaler Schwellwert ($O_{min}$) festgelegt wird.

8. Verfahren nach einem der Ansprüche 1 bis 7, **dadurch gekennzeichnet, dass** die vorgegebene Differenz ($TR_{max}$) entsprechend einer Kompression für eine schwerhörende Person angepasst wird.

9. Vorrichtung zur Durchführung des Verfahrens nach einem der Ansprüche 1 bis 8, **dadurch gekennzeichnet, dass** eine Verarbeitungseinheit vorgesehen ist, dem ein Eingangssignal beaufschlagt ist, dass ein Schwellwert ($O_{max}$, $O_{min}$, $O_{TR}$) zur Begrenzung des Ausgangssignals in der Verarbeitungseinheit bestimmbar ist, dass ein Mittelwert eines Pegels des Eingangssignals s(t) bestimmbar ist, wobei der Schwellwert ($O_{max}$, $O_{min}$, $O_{TR}$) in Funktion des Mittelwertes des Pegels des Eingangssignals einstellbar ist, und dass das Ausgangssignal im Hörgerät durch Anwenden des Schwellwertes ($O_{max}$, $O_{min}$, $O_{TR}$) limitierbar ist, wobei der Schwellwert ($O_{max}$, $O_{min}$, $O_{TR}$) auf einen oberen Wert einstellbar ist, der dem Mittelwert plus einer vorgegebenen Differenz ($TR_{max}$) entspricht, und wobei das Ausgangssignal auf den oberen Wert begrenzbar ist, wenn das Ausgangssignal höher wäre als der obere Wert.

10. Vorrichtung nach Anspruch 9, **dadurch gekennzeichnet, dass** bei der Bestimmung des Mittelwertes des Pegels des Eingangssignals ausschliesslich im Eingangssignal enthaltene Umgebungsgeräusche berücksichtigbar sind.

11. Vorrichtung nach Anspruch 9 oder 10, **dadurch gekennzeichnet, dass** die vorgegebene Differenz ($TR_{max}$) zwanzig Dezibel beträgt.

12. Vorrichtung nach Anspruch 11, **dadurch gekennzeichnet, dass** der Mittelwert aus dem Eingangssignal s(t) nach folgender Formel bestimmbar ist:

$$I = \frac{1}{T} \cdot \int_0^T |s(t)| \cdot dt \ ,$$

wobei eine Mittelung über ein Zeitintervall T vornehmbar ist, das vorzugsweise fünf Sekunden beträgt.

13. Vorrichtung nach einem der Ansprüche 9 bis 12, **dadurch gekennzeichnet, dass** ein maximaler Schwellwert ($O_{max}$) festlegbar ist.

14. Vorrichtung nach Anspruch 13, **dadurch gekennzeichnet, dass** der maximale Schwellwert ($O_{max}$) gleich einem oberen Komfortpegel einer schwerhörenden Person wählbar ist.

15. Vorrichtung nach einem der Ansprüche 9 bis 14, **dadurch gekennzeichnet, dass** ein minimaler Schwellwert ($O_{min}$) festlegbar ist.

16. Vorrichtung nach Anspruch 15, **dadurch gekennzeichnet, dass** der minimale Schwellwert ($O_{min}$)

gleich einer mittleren Verstärkung einer schwerhörenden Person wählbar ist.

17. Vorrichtung nach einem der Ansprüche 9 bis 16, **dadurch gekennzeichnet, dass** die vorgegebene Differenz (TR$_{max}$) entsprechend einer Kompression einer schwerhörenden Person einstellbar ist.


**Claims**

1. Method for determining a threshold value (Q$_{max}$, Q$_{min}$, Q$_{TR}$) in a hearing device, the threshold value (Q$_{max}$, Q$_{min}$, Q$_{TR}$) serving for the limitation of an output signal of a processing unit, to which an input signal s(t) is fed, **characterized in that** a mean value of a level of the input signal s(t) is determined, that the threshold value (Q$_{max}$, Q$_{min}$, Q$_{TR}$) is adjusted as a function of the mean value, that the output signal is limited in the hearing device by using the threshold value (Q$_{max}$, Q$_{min}$, Q$_{TR}$), the threshold value (Q$_{max}$, Q$_{min}$, Q$_{TR}$) being adjusted to an upper value, which corresponds to the mean value plus a preset difference (TR$_{max}$), and the output signal being limited to the upper value, if the output signal would be higher than the upper value.

2. Method according to claim 1, **characterized in that** surrounding noises solely comprised in the input signal are considered for the determination of the mean value of the level of the input signal.

3. Method according to claim 1 or 2, **characterized in that** the preset difference (TR$_{max}$), is equal to twenty decibels.

4. Method according to claim 1 or 2, **characterized in that** the mean value is determined from an input signal s(t) according to following formula:

$$I = \frac{1}{T} \cdot \int_0^T |s(t)| \cdot dt \ ,$$

an averaging over a time interval T being carried out, which preferably equals to five seconds.

5. Method according to one of the claims 1 to 4, **characterized in that** a maximum threshold value (Q$_{max}$) is determined.

6. Method according to claim 5, **characterized in that** the maximum threshold value (Q$_{max}$) is selected equal to an upper comfort level of a hearing impaired person.

7. Method according to one of the claims 1 to 6, **characterized in that** a minimum threshold value (Q$_{min}$) is determined.

8. Method according to one of the claims 1 to 7, **characterized in that** the preset difference (TR$_{max}$) is adjusted according to a compression of a hearing impaired person.

9. Device for carrying out the method according to one of the claims 1 to 8, **characterized in that** a processing unit is provided on which an input signal is impinged, that a threshold value (Q$_{max}$, Q$_{min}$, Q$_{TR}$) for the limitation of the output signal in the processing unit is determinable, that a mean value of a level of the input signal s(t) is determinable, the threshold value (Q$_{max}$, Q$_{min}$, Q$_{TR}$) being adjustable as a function of the mean value of the level of the input signal, and that the output signal in the hearing device is limitable by using the threshold Value (Q$_{max}$, Q$_{min}$, Q$_{TR}$), the threshold value (Q$_{max}$, Q$_{min}$, Q$_{TR}$) being adjustable to an upper value, which corresponds to the mean value plus a preset difference (TR$_{max}$), and the output signal being limitable to the upper value, if the output signal would be higher than the upper value.

10. Device according to claim 9, **characterized in that** surrounding noises solely comprised in the input signal are considered for the determination of the mean value of the level of the input signal.

11. Device according to claim 9 or 10, **characterized in that** the preset difference (TR$_{max}$) equals to twenty decibels.

12. Device according to claim 11, **characterized in that** the mean value is determinable from the input signal s(t) according to following formula:

$$I = \frac{1}{T} \cdot \int_0^T |s(t)| \cdot dt \ ,$$

an averaging over a time interval T being conductable, which preferably equals to five seconds.

13. Device according to one of the claims 9 to 12, **characterized in that** a maximum threshold value (Q$_{max}$) is selectable.

14. Device according to claim 13, **characterized in that** the maximum threshold value (Q$_{max}$) is selectable equal to an upper comfort value of a hearing impaired person.

**15.** Device according to one of the claims 9 to 14, **characterized in that** a minimum threshold value ($Q_{min}$) is selectable.

**16.** Device according to claim 15, **characterized in that** the minimum threshold value ($Q_{min}$) is selectable equal to an average amplification of a hearing impaired person.

**17.** Device according to one of the claims 9 to 16, **characterized in that** the preset difference ($TR_{max}$) is selectable corresponding to a compression of a hearing impaired person.

**Revendications**

**1.** Procédé pour déterminer une valeur de seuil ($Q_{max}$, $Q_{min}$, $Q_{TR}$) dans une prothèse auditive, la valeur de seuil ($Q_{max}$, $Q_{min}$, $Q_{TR}$) servant à limiter un signal de sortie d'une entité de traitement, à laquelle un signal d'entrée s(t) est alimentée, **caractérisé en ce qu'**une valeur moyenne d'un niveau du signal d'entrée s(t) est déterminée, que la valeur de seuil ($Q_{max}$, $Q_{min}$, $Q_{TR}$) étant adaptée en fonction de la valeur moyenne, que le signal de sortie dans la prothèse auditive est limitée en appliquant la valeur de seuil ($Q_{max}$, $Q_{min}$, $Q_{TR}$), la valeur de seuil ($Q_{max}$, $Q_{min}$, $Q_{TR}$) étant adaptée à une valeur supérieure, qui correspond à la valeur moyenne en plus d'une différence prédéterminée ($TR_{max}$), et le signal de sortie étant limité à la valeur supérieure, si le signal de sortie serait plus haut que la valeur supérieure.

**2.** Procédé selon la revendication 1, **caractérisé en ce que** pour déterminer la valeur moyenne du niveau du signal d'entrée seulement des bruits d'environnement compris dans le signal d'entrée sont considérés.

**3.** Procédé selon la revendication 1 ou 2, **caractérisé en ce que** la différence prédéterminée ($TR_{max}$) se monte à vingt décibels.

**4.** Procédé selon la revendication 1 ou 2, **caractérisé en ce que** la valeur moyenne est déterminée du signal d'entrée s(t) selon la formule suivante:

$$I = \frac{1}{T} \cdot \int_0^T |s(t)| \cdot dt \ ,$$

en faisant la moyenne sur un intervalle de temps T, qui se monte préférablement à cinq seconds.

**5.** Procédé selon une des revendications 1 à 4, **caractérisé en ce qu'**une valeur de seuil maximale ($Q_{max}$) est déterminée.

**6.** Procédé selon la revendication 5, **caractérisé en ce que** la valeur de seuil maximale ($Q_{max}$) est sélectée égale à une valeur de confort supérieure d'une personne malentendante.

**7.** Procédé selon une des revendications 1 à 6, **caractérisé en ce qu'**une valeur de seuil minimale ($Q_{min}$) est déterminée.

**8.** Procédé selon une des revendications 1 à 7, **caractérisé en ce que** la différence prédéterminée ($TR_{max}$) est adaptée selon une compression d'une personne malentendante.

**9.** Dispositif à appliquer le procédé selon une des revendications 1 à 8, **caractérisé en ce qu'**une entité de traitement est prévue, à laquelle un signal d'entrée est alimentée, qu'une valeur de seuil ($Q_{max}$, $Q_{min}$, $Q_{TR}$) pour limiter le signal de sortie dans le signal de traitement est déterminable, qu'une valeur moyenne d'un niveau du signal d'entrée s(t) est déterminable, la valeur de seuil ($Q_{max}$, $Q_{min}$, $Q_{TR}$) en fonction de la valeur moyenne du niveau du signal d'entrée étant adaptable, et que le signal de sortie dans la prothèse auditive est limitable par appliquant la valeur de seuil ($Q_{max}$, $Q_{min}$, $Q_{TR}$), la valeur de seuil ($Q_{max}$, $Q_{min}$, $Q_{TR}$) étant adaptable à une valeur supérieure, qui correspond à la valeur moyenne en plus d'une différence prédéterminée ($TR_{max}$), et le signal de sortie étant limitable à la valeur supérieure, si le signal de sortie serait plus haut que la valeur supérieure.

**10.** Dispositif selon la revendication 9, **caractérisé en ce que** pour déterminer la valeur moyenne du niveau du signal d'entrée seulement des bruits d'environnement compris dans le signal d'entrée sont considérables.

**11.** Dispositif selon la revendication 9 ou 10, **caractérisé en ce que** la différence prédéterminée ($TR_{max}$) se monte à vingt décibels.

**12.** Dispositif selon la revendication 11, **caractérisé en ce que** la valeur moyenne du signal d'entrée s(t) est déterminable selon la formule suivante:

$$I = \frac{1}{T} \cdot \int_0^T |s(t)| \cdot dt \ ,$$

la moyenne sur un intervalle de temps T pouvant être faite, qui se monte préférablement à cinq seconds.

**13.** Dispositif selon une des revendications 9 à 12, **caractérisé en ce qu'**une valeur de seuil maximale ($Q_{max}$) est déterminable.

**14.** Dispositif selon la revendication 13, **caractérisé en ce que** la valeur de seuil maximale ($Q_{max}$) est sélectable égale un niveau de confort supérieure d'une personne malentendante.

**15.** Dispositif selon une des revendications 9 à 14, **caractérisé en ce qu'**une valeur de seuil minimale ($Q_{min}$) est sélectable.

**16.** Dispositif selon la revendication 15, **caractérisé en ce que** la valeur de seuil minimale ($Q_{min}$) est sélectable égale à une amplification moyenne d'une personne malentendante.

**17.** Dispositif selon une des revendications 9 à 16, **caractérisé en ce que** la différence prédéterminée ($TR_{max}$) est adaptable selon une compression d'une personne malentendante.

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4182993 A